# EUROPÄISCHE PATENTSCHRIFT

(11) **EP 0 520 214 B1**
(45) Veröffentlichungstag und Bekanntmachung des Hinweises auf die Patenterteilung: **18.09.1996**
(21) Anmeldenummer: 92109303.5
(22) Anmeldetag: 02.06.1992
(51) Int. Cl.: H01L 21/225, H01L 21/331, H01L 29/10

(54) **Verfahren zur Herstellung eines dotierten Gebietes in einem Substrat und Anwendung bei der Herstellung eines Bipolartransistors**
Method of forming a doped region in a substrate and use in the fabrication of a bipolar transistor
Méthode de formation d'une région dopée dans un substrat et application à la fabrication d'un transistor bipolaire

(30) Priorität: 19.06.1991 DE 4120268
(43) Veröffentlichungstag der Anmeldung: 30.12.1992
(73) Patentinhaber: SIEMENS AKTIENGESELLSCHAFT, 80333 München (DE)
(72) Erfinder: Ehinger, Karl, Dr. Dipl.-Phys., W-7500 Karlsruhe 51 (DE); Bianco, Michael, Dipl.-Phys., W-8000 München 83 (DE); Klose, Helmut, Dr. Dipl.-Ing., W-8000 München 83 (DE)

(56) Entgegenhaltungen:
- EP-A- 0 339 385
- EP-A- 0 339 385
- EP-A- 0 367 729
- EP-A- 0 367 729
- WO-A-86/04454
- WO-A-86/04454
- NEC RESEARCH AND DEVELOPMENT. Nr. 90, Juli 1988, TOKYO JP Seiten 10 - 13; HISASHI TAKEMURA ET AL.: 'BSA technology for sub-100nm deep base bipolar transistors'
- PATENT ABSTRACTS OF JAPAN vol. 14, no. 178 (E-915)10. April 1990

## Beschreibung

Bei der Herstellung integrierter Schaltungen werden in Halbleitersubstraten, z. B. aus einkristallinem Silizium, Dotierstoffverteilungen erzeugt. Diese Dotierstoffverteilungen sind in den meisten Fällen örtlich begrenzt. Senkrecht zur Substratoberfläche weisen die Dotierstoffverteilungen dabei ein vorgegebenes Profil mit einem entsprechenden Gradienten auf.

Dotierstoffe werden in Substrate durch Ionenimplantation oder Diffusion eingebracht. Bei der Ionenimplantation wird die Verteilung im Substrat durch eine Maske begrenzt, die mit Hilfe von Photolithographie hergestellt wird. Bei der Herstellung von Dotierstoffverteilungen mit Hilfe von Diffusion werden an der Oberfläche des Substrats z. B. dotierte Schichten angeordnet, aus denen der Dotierstoff ausdiffundiert. Die Form der Verteilung in der Ebene der Substratoberfläche wird dabei z. B. durch entsprechende Formgebung der dotierten Schicht bestimmt. Dazu wird die dotierte Schicht nach entsprechender photolithographischer Definition strukturiert.

Aus EP-A-36 77 29 ist ein Verfahren zur Herstellung von BOX-Isolationsstrukturen bekannt. Dabei wird auf senkrechte Wände von in ein Substrat geätzten Gräben eine Barriereschicht aus thermischem SiO₂ aufgewachsen. Darauf wird eine Borsilikatglasschicht als Diffusionsquelle mit einem Dotierstoffgehalt von weniger oder höchstens 1 Gewichtsprozent abgeschieden. Durch Ausdiffusion aus der Borsilikatglasschicht wird ein dotiertes Gebiet im Substrat hergestellt.

Aus EP-A-33 93 85 ist bekannt, eine Borsilikatglasschicht durch Zersetzung von Tristrimethylsilylborat (B(OSi(CH₃)₃)₃) herzustellen. Es wird darauf hingewiesen, daß eine auf diese Weise hergestellte Borsilikatglasschicht als Diffusionsquelle verwendet werden kann. Die erzielbare Borkonzentration im Substrat läßt sich dabei über den Borgehalt im Borsilikatglas, über die Temperatur, die Dauer und den Ambienten während des Eintreibschrittes steuern. Der Borgehalt solcher Borsilikat-glasschichten liegt zwischen 0,5 und 6 Gewichtsprozent.

Das Dotierstoffprofil senkrecht zur Oberfläche des Substrats wird bei der Implantation im wesentlichen durch die Dosis und die Implantationsenergie bestimmt. Bei der Diffusion aus einer dotierten Schicht wird das Dotierstoffprofil senkrecht zur Substratoberfläche durch die in der dotierten Schicht enthaltene Dotierstoffmenge, die Segregation an der Grenzfläche zum Substrat und die Diffusionslänge bestimmt.

Bei der Herstellung flacher Dotierstoffprofile d. h. von Profilen mit geringer Eindringtiefe der Dotierstoffe sind bei Verwendung der Ionenimplantation dadurch Grenzen gesetzt, daß die Reichweite aer Ionen in bestimmten Kristallrichtungen durch den Channeling-Effekt sehr groß ist. Ein weiteres praktisches Problem ist darin zu sehen, daß nur wenige Implantationsanlagen angeboten werden, mit denen eine Implantation mit weniger als 10 keV Implantationsenergie möglich ist. Solch geringe Energien sind jedoch erforderlich, um flache Dotierstoffprofile mit steilem Gradienten herzustellen.

Bei der Herstellung von Bipolartransistoren mit sehr kurzen Schaltzeiten werden sehr geringe Eindringtiefen für Emitter/Basis- und Basis/Kollektor-Übergänge angestrebt. Im selbstjustierten Doppelpolysiliziumprozeß werden sowohl Basisanschlüsse als auch Emitteranschluß aus entsprechend dotiertem Polysilizium gebildet. Der Basisanschluß wird gegen den Emitteranschluß durch ein, nach einer unmaskierten, anisotropen Ätzung einer Oxidschicht zurückgebliebenes Ätzresiduum, den sogenannten SiO₂-Spacer, isoliert (s. H. Kabza et al, IEEE-EDL (1989) Bd. 10, S. 344 - 346). Innerhalb der durch die Ätzresiduen definierten Fläche wird die aktive Basis hergestellt. Der Kontakt zwischen dem Basisanschluß und der aktiven Basis wird durch ein die aktive Basis ringförmig umgebendes, dotiertes Gebiet im Substrat unterhalb des Basisanschlusses gewährleistet. Dieses Gebiet wird inaktive Basis, auch externer Basisanschluß oder extrinsische Basis genannt. Die inaktive Basis muß die aktive Basis bei einer ausreichenden Dotierstoffkonzentration überlappen, um einen niederohmigen Basisanschluß-Widerstand zu liefern. Die inaktive Basis wird dabei durch Ausdiffusion aus dem Basisanschluß hergestellt.

Wird die aktive Basis nach der Bildung der Ätzresiduen hergestellt, so kommt es zu einem zu hochohmigen Basisanschlußwiderstand, weil die aktive Basis und die inaktive Basis sich entweder nicht oder nur bei zu geringer Dotierstoffkonzentration überlappen (s. K. Ehinger et al, Proc. of ESSDERC, J. Phys., C4, S. 109 - 112 (1988)).

Sehr steile Basis- und Emitterprofile mit geringer Eindringtiefe werden durch die sogenannte Doppeldiffusion erzielt. Unter Doppeldiffusion wird die sukzessive Diffusion von verschiedenen Dotierstoffen aus derselben polykristallinen Siliziumschicht verstanden. In diesem Fall wird die polykristalline Siliziumschicht für den Emitteranschluß zunächst mit Bor dotiert, dessen Ausdiffusion zur Bildung der aktiven Basis führt, und dann mit Arsen dotiert, dessen Ausdiffusion zur Ausbildung des Emitters führt. Der Überlapp von aktiver Basis und inaktiver Basis ist bei diesem Herstellverfahren ungenügend (s. K. Ehinger et al, Proc. of ESSDERC, J. Phys., C 4, S. 109 - 112 (1988)).

Dieses Problem kann auf verschiedene Weisen gelöst werden: Die Basis kann vor der Bildung der Ätzresiduen durch Implantation hergestellt werden. Dadurch ist die Basis seitlich bis an den Rand des Basisanschlusses ausgedehnt. Damit ist zwar eine gute Überlappung zwischen aktiver und inaktiver Basis gegeben, es entstehen jedoch Implantationsschäden im aktiven Bereich des Transistors, die zu einer Reduzierung der Ausbeute führen können. Außerdem kann die Eindringtiefe der Dotierstoffe für die Basis wegen der Verwendung der Implantation nicht beliebig klein gemacht werden.

Eine andere Möglichkeit besteht darin, vor der Bildung der Ätzresiduen einen Teil der Dotierstoffkonzentration für die aktive Basis mit geringer Energie zu implantieren. Anschließend wird durch Ausdiffusion aus der für den Emitteranschluß vorgesehenen, polykristallinen Siliziumschicht der Endwert der Basisdotierung eingestellt (s. T. Yamaguchi et al, IEEE - ED (1988) Bd. 35, S. 1247 - 1256). Dadurch wird jedoch die Dotierstoffkonzentration der aktiven Basis unter dem Emitterfenster vergrößert und das Basisprofil dabei verbreitert.

Eine weitere Lösungsmöglichkeit besteht darin, das den Basisanschluß vom Emitteranschluß isolierende Ätzresiduum mit Bor zu dotieren (s. M. Nakamae, Proc. of ESSDERC (1987), S. 361 - 363). Durch Ausdiffusion aus dem Ätzresiduum wird die Dotierstoffkonzentration lokal an der Anschlußstelle inaktive Basis/aktive Basis erhöht. Die dabei erzielte Dotierstoffkonzentration ist vorgegeben durch die im Ätzresiduum deponierte Dotierstoffmenge, die Segregation an der Grenzfläche zum Substrat und die Diffusionslänge. Um den Basisanschlußwiderstand kontrolliert einstellen zu können, muß das Ätzresiduum daher aus einer SiO₂-Verbindung gebildet werden, dessen Ausdiffusion bei vorgegebenem Temperaturbudget geeignet variierbar ist.

Es hat sich herausgestellt, daß in beliebiger Konzentration dotierbare bordotierte SiO₂-Verbindungen, wie sie in M. Nakamae, Proc. of ESSDERC (1987), S. 361 - 363 verwendet werden, sich in einem metastabilen Zustand befinden. Dadurch kommt es stellenweise zu Kristallisationen des Glases. An diesen Stellen ist dann die Charakteristik der Ausdiffusion verändert, so daß es zu großen ortsabhängigen Inhomogenitäten der Dotierstoffverteilung im Substrat kommt. Dieses wirkt sich negativ auf die gleichmäßige Einstellung eines niedrigen Basisanschlußwiderstands aus.

Der Erfindung liegt das Problem zugrunde, ein Verfahren zur Herstellung eines dotierten Gebietes in einem Substrat anzugeben, mit dem die Dotierstoffverteilung auch bei einer geringen Eindringtiefe und einem steilen Gradienten des Dotierstoffes gut kontrollierbar ist und das bei der Herstellung eines Bipolartransistors zur lokalen Erhöhung der Dotierstoffkonzentration an der Anschlußstelle inaktive Basis/aktive Basis geeignet ist.

Dieses Problem wird erfindungsgemäß gelöst in einem Verfahren nach Anspruch 1.

Die Zwischenschicht begrenzt dabei die Ausdiffusion der Dotierstoffe in das Substrat. Durch Variation der Dicke und/oder der Dichte der Zwischenschicht wird die entstehende Dotierstoffverteilung in dem dotierten Gebiet festgelegt. Die Zwischenschicht wird z. B. aus SiO₂, Si₃N₄, TiN usw. gebildet.

Da sich die Dichte einer SiO₂-Schicht mit den Herstellungs-bzw. Abscheidebedingungen ändert, kann bei Verwendung einer SiO₂-Schicht durch entsprechende Wahl der Prozeßparameter Einfluß auf die entstehende Dotierstoffverteilung genommen werden. Beispielsweise zeigt thermisch erzeugtes SiO₂ bei gleicher Dicke eine größere Diffusionsbarrierewirkung als SiO₂, das durch Zersetzung von Si (OC₂H₅)₄ (sogenanntes TEOS) in einem CVD-Abscheidereaktor erzeugt wurde.

Als dotierte Glasschicht wird insbesondere eine Bor-dotierte Glasschicht verwendet, die durch CVD-Abscheidung von B(OSi(CH₃)₃)₃ erzeugt wird. Eine so hergestellte dotierte Glasschicht zeigt keinerlei Kristallisation. Da in diesem Fall jedes abgeschiedene Molekül den Dotierstoff enthält, ist die Dotierstoffkonzentration des Bors in der so hergestellten dotierten Glasschicht konstant. Eine solche dotierte Glasschicht stellt bei ausreichender Dicke praktisch eine unendliche Borquelle dar, was auch durch Messungen belegt ist.

Durch Verwendung der Zwischenschicht kann eine so hergestellte, dotierte Glasschicht als Diffusionsquelle für dotierte Gebiete mit unterschiedlicher Eindringtiefe des Dotierstoffs Bor verwendet werden. Dabei liegt es im Rahmen der Erfindung, thermisch erzeugte Oxide mit Dicken bis zu 30 nm oder CVD-erzeugte SiO₂-Schichten mit Dicken zwischen 10 nm und 100 nm zu verwenden. Die Zwischenschicht wirkt als Diffusionsbarriere und reduziert dadurch die Oberflächenkonzentration des Bors und damit die Eindringtiefe des Bors in das Substrat. Durch Variation der lokalen Dicke der Zwischenschicht kann darüberhinaus die Eindringtiefe des Dotierstoffs lokal gezielt eingestellt werden.

Die Formgebung des dotierten Gebietes in der Ebene parallel zur Oberfläche des Substrats erfolgt z. B. durch Strukturierung der dotierten Glasschicht unter Verwendung von Photolithographie vor der Ausdiffusion. Auf diese Weise wird das dotierte Gebiet auf die mit der verbleibenden dotierten Glasschicht bedeckte Oberfläche des Substrats begrenzt. Dabei liegt es im Rahmen der Erfindung, die dotierte Glasschicht und die Zwischenschicht nach dem Temperaturschritt zur Ausdiffusion des Dotierstoffes wieder zu entfernen. Diese Ausführungsform findet insbesondere Anwendung bei der Herstellung einer aktiven Basis eines Bipolartransistors nach dem erfindungsgemäßen Verfahren.

In einer weiteren Ausführungsform der Erfindung wird vor der Erzeugung der Zwischenschicht an der Oberfläche des Substrats eine Struktur gebildet, die eine zur Oberfläche des Substrats senkrechte Flanke aufweist. Die Zwischenschicht wird ganzflächig und konform auf der mit der Struktur versehenen Oberfläche des Substrats erzeugt. Darauf wird wiederum ganzflächig und konform die dotierte Glasschicht erzeugt. In einem anisotropen Ätzprozeß werden die dotierte Glasschicht und die Zwischenschicht zurückgeätzt, so daß an der senkrechten Flanke ein Ätzresiduum (Spacer) entsteht. Das dotierte Gebiet im Substrat wird dann in einem Temperaturschritt durch Ausdiffusion aus dem Ätzresiduum gebildet. In dem Ätzresiduum ist aufgrund der Herstellvorschrift zwischen der Oberfläche des Substrats und dem Teil aus dotierten Glas weiterhin ein Teil der Zwischenschicht angeordnet, die die Ausdiffusion begrenzt.

In dieser Ausführungsform wird das dotierte Gebiet selbstjustiert zur Flanke der Struktur hergestellt. Bei der Spacerbildung ist keinerlei photolithographischer Schritt erforderlich. Diese Ausführungsform der Erfindung ist besonders geeignet, um bei der Herstellung eines Bipolartransistors einen guten Überlapp zwischen dessen aktiver und inaktiver Basis sicherzustellen. Das Ätzresiduum wird in diesem Fall an einer dem Emitterfenster zugewandten Flanke eines Basisanschlusses aus polykristallinem Silizium gebildet. Da die inaktive Basis durch Ausdiffusion aus dem Basisanschluß gebildet wird und die aktive Basis innerhalb des mit dem Ätzresiduum versehenen Emitterfensters gebildet wird, stellt das aus dem Ätzresiduum erfindungsgemäß erzeugte dotierte Gebiet einen guten Kontakt zwischen aktiver Basis und inaktiver Basis her.

Weitere Ausgestaltungen der Erfindung gehen aus den übrigen Ansprüchen hervor.

Im folgenden wird die Erfindung anhand von Ausführungsbeispielen und der Figuren näher erläutert.
- Fig. 1 und Fig. 2: zeigt die Herstellung eines dotierten Gebietes durch Ausdiffusion aus einer dotierten Glasschicht, die mit Hilfe eines photolithographischen Schrittes strukturiert wurde.
- Fig. 3 und Fig. 4: zeigt die Herstellung eines dotierten Gebietes aus einem selbstjustiert gebildeten Ätzresiduum aus dotiertem Glas.
- Fig. 5 und Fig. 6: zeigt die Herstellung eines Bipolartransistors, bei dem die aktive Basis durch Ausdiffusion aus einer dotierten Glasschicht erzeugt wird.
- Fig. 7: zeigt die Herstellung einer Verbindung zwischen einer aktiven Basis und einer inaktiven Basis eines Bipolartransistors.

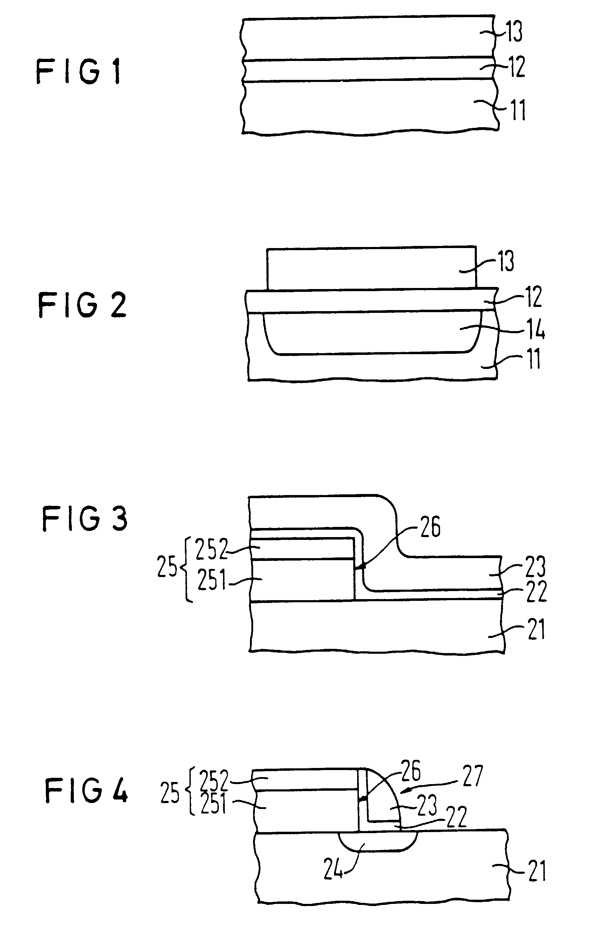

Auf einem Substrat 11 aus einkristallinem Silizium wird eine Zwischenschicht 12 aus SiO₂ erzeugt (s. Fig. 1). Die Zwischenschicht 12 wird z. B. durch thermische Oxidation der Oberfläche des Substrats 11 in einer Dicke von z. B. bis zu 30 nm oder durch Abscheidung von SiO₂ aus der Gasphase nach Zersetzung von Si(OC₂H₅)₄ (sogenanntes TEOS) in einer Dicke von z. B. 20 nm gebildet.

Auf der Zwischenschicht 12 wird eine dotierte Glasschicht 13 gebildet. Die dotierte Glasschicht 13 wird durch CVD-Abscheidung von (B(0Si(CH₃)₃)₃) bei einer Temperatur von z. B. 800 bis 850 °C, vorzugsweise 840 °C, gebildet. Die dotierte Glasschicht 13 wird z. B. in einer Dicke von 100 nm erzeugt. Sie weist eine Dotierstoffkonzentration des Bors von etwa 4,3 x 10²² cm⁻³ auf.

Nach entsprechender Maskierung mit Hilfe von Photolithographie wird die dotierte Glasschicht 13 so strukturiert, daß sie die Oberfläche des Substrats 11 bedeckt in dem Bereich, in dem ein dotiertes Gebiet 14 gebildet werden soll. In einem Temperaturschritt bei z. B. 1050 °C wird das dotierte Gebiet 14 durch Ausdiffusion des Dotierstoffes aus der dotierten Glasschicht 13 durch die Zwischenschicht 12 hindurch im Substrat 11 gebildet. Die Tiefe des dotierten Gebietes 14 hängt dabei ab von der Dicke und Dichte der Zwischenschicht 12 (s. Fig. 2).

Auf einem Substrat 21 aus einkristallinem Silizium wird eine Struktur 25 mit einer senkrechten Flanke 26 erzeugt (s. Fig. 3). Die Struktur 25 wird aus einer Polysiliziumschicht 251 und einer darauf angeordneten SiO₂-Schicht 252 gebildet. Auf der mit der Struktur 25 versehenen Oberfläche des Substrats 21 wird ganzflächig und konform eine Zwischenschicht 22 erzeugt. Die Zwischenschicht 22 wird z. B. durch thermische Oxidation oder durch CVD-Abscheidung von TEOS in einer Dicke von z. B. 20 nm gebildet. Auf der Zwischenschicht 22 wird eine dotierte Glasschicht 23 ganzflächig und konform abgeschieden. Die dotierte Glasschicht 23 wird z. B. durch CVD-Abscheidung von B(OSi(CH₃)₃)₃ gebildet.

In einem anisotropen Ätzprozeß werden die dotierte Glasschicht 23 und die Zwischenschicht 22 rückgeätzt, so daß ein Ätzresiduum, ein sogenannter Spacer 27, an den Flanken entsteht, während alle ebenen Bereiche freigeätzt werden. Der Spacer 27 ist an der Flanke 26 der Struktur 25 angeordnet (s. Fig. 4). In einem Temperaturschritt bei z. B. 1050 °C, 20 sec. lang wird durch Ausdiffusion des Dotierstoffes aus der dotierten Glasschicht 23 durch die Zwischenschicht 22 in das Substrat 21 ein dotiertes Gebiet 24 erzeugt. Die Lage des dotierten Gebietes 24 zur Flanke 26 der Struktur 25 ist dabei selbstjustiert durch die Spacertechnik.

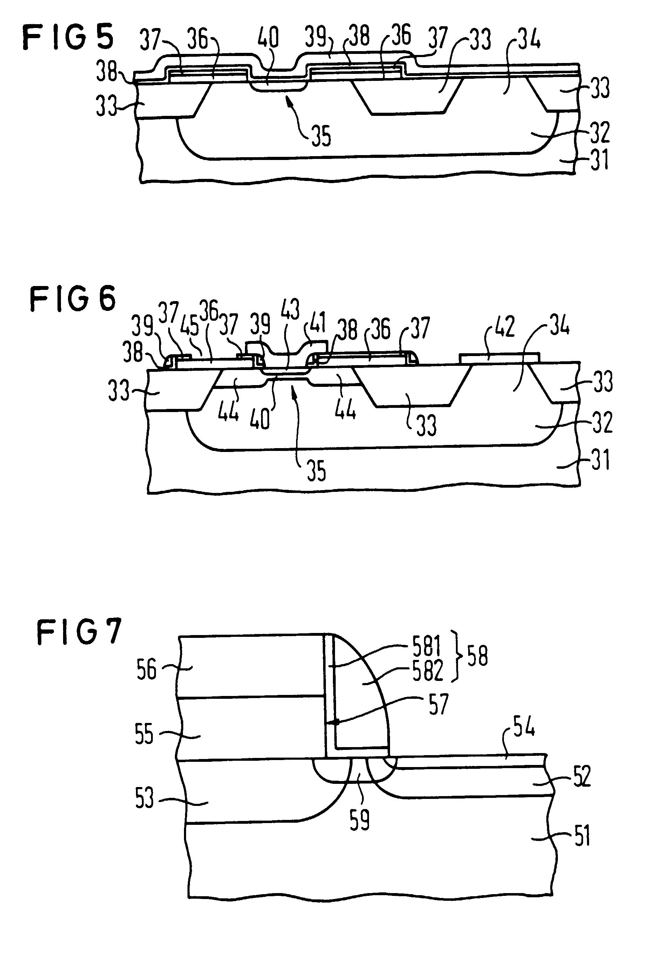

Das erfindungsgemäße Verfahren ist zum Einsatz bei der Herstellung eines Bipolartransistors geeignet. Es ist insbesondere auch geeignet zur Herstellung einer aktiven Basis bei einem Bipolartransistor in einem Doppelpolysiliziumprozeß, wie er z. B. in H. Kabza et al, IEEE-EDL (1989) Bd. 10, S. 344 - 346 beschrieben ist. In einem p-dotierten Siliziumsubstrat 31 ist zur Aufnahme der aktiven Teile des Bipolartransistors ein n⁺-dotierter Bereich 32 angeordnet. Feldoxidbereiche 33 isolieren den n-dotierten Bereich 32 an der Oberfläche des Substrats 31 im Substrat 31 gegen benachbarte Schaltelemente im Substrat 31. Des weiteren isoliert ein Feldoxidbereich 33 einen im n⁺-dotierten Bereich 32 angeordneten tiefreichenden Kollektoranschluß 34 gegen den aktiven Transistorbereich 35. An der Oberfläche des Substrats 31 ist ein Basisanschluß 36 angeordnet. Der Basisanschluß 36 besteht aus B-dotiertem Polysilizium. Der Basisanschluß 36 umgibt den aktiven Transistorbereich 35 ringförmig. Der Basisanschluß 36 ist an seiner Oberfläche mit einer Isolationsstruktur 37 aus z. B. SiO₂ versehen. Eine Zwischenschicht 38 aus z. B. thermisch erzeugtem Siliziumoxid in einer Dicke von bis zu 30 nm ist an der Oberfläche der Isolationsstruktur 37 und des aktiven Transistorbereichs 35 angeordnet. Auf der Zwischenschicht 38 ist eine dotierte Glasschicht 39 angeordnet. Die dotierte Glasschicht 39 ist z. B. durch CVD-Abscheidung von B(OSi(CH₃)₃)₃ bei z. B. 840 °C erzeugt worden. Die dotierte Glasschicht 39 weist eine Dicke von z. B. 100 nm auf. Durch einen Temperaturschritt bei z. B. 1050 °C während z. B. 20 sec. wird durch Ausdiffusion des Dotierstoff Bor aus der dotierten Glasschicht 39 durch die Zwischenschicht 38 in den aktiven Transistorbereich 35 hinein eine aktive Basis 40 erzeugt (s. Fig. 5). Die Basisweite der aktiven Basis 40 (d. h. die Eindringtiefe des Dotierstoffes) beträgt z. B. 85 nm.

Nach Entfernen der dotierten Glasschicht 39 und der Zwischenschicht 38, so daß an den Flanken Ätzresiduen aus Bor-dotiertem Glas und darunterliegendem Oxid stehen bleiben, während die ebenen Flächen freigeätzt sind, wird ein Emitteranschluß 41 und ein Kollektoranschluß 42 jeweils aus n-dotiertem Polysilizium gebildet (s. Fig. 6). Der Emitteranschluß 41 wird dabei oberhalb des aktiven Transistorbereichs 35 gebildet. Der Kollektoranschluß 42 wird oberhalb des tiefreichenden Kollektoranschluß 34 gebildet. Nach Ausdiffusion von Dotierstoff aus dem Emitteranschluß 41 zur Bildung eines Emitters 43 und nach Ausdiffusion von Dotierstoff aus dem Basisanschluß 36 zur Bildung einer inaktiven Basis 44, die die aktive Basis 40 ringförmig umgibt und anschließt, wird der Bipolartransistor durch Öffnen eines Kontaktloches 45 auf den Basisanschluß 36 fertiggestellt (s. Fig. 6).

Das erfindungsgemäße Verfahren ist auch geeignet zur Verbesserung des Kontaktes zwischen einer aktiven Basis und einer inaktiven Basis in einem Bipolartransistor. In Fig. 7 ist ein Ausschnitt aus einem Bipolartransistor dargestellt. In einem n-dotierten Bereich 51 eines Siliziumsubstrates sind eine aktive Basis 52 und eine inaktive Basis 53 angeordnet. An der Oberfläche des Substrats ist im Bereich der aktiven Basis 52 ein Emitter 54 angeordnet. Oberhalb der inaktiven Basis 53 ist auf der Oberfläche des Substrats ein Basisanschluß 55 aus B-dotiertem Polysilizium angeordnet. Der Basisanschluß 55 ist mit einer Oxidschicht 56 bedeckt. Die Oxidschicht 56 und der Basisanschluß 55 weisen eine gemeinsame, zur Oberfläche des Substrats senkrechte Flanke 57 auf.

Aus einer z. B. 10 nm dicken Zwischenschicht aus thermischen Oxid, die auf der Oberfläche der Oxidschicht 56, der Flanke 57 und des Substrats angeordnet ist, und aus einer darauf angeordneten dotierten Glasschicht wird ein Spacer 58 an der Flanke 57 gebildet. Dies erfolgt durch anisotropes Rückätzen, wie anhand von Fig. 3 und 4 ausführlich beschrieben. Der Spacer 58 weist eine die Flanke 57 und die Oberfläche des Substrats bedeckende Schicht 581 aus thermischem Oxid und einen Anteil 582 aus dotiertem Glas auf. Die dotierte Glasschicht wird durch CVD-Abscheidung von B(OSi(CH₃)₃)₃ erzeugt. In einem Temperaturschritt bei z. B. 1050 °C wird der Dotierstoff aus dem Teil 582 des Spacers 58 durch die Schicht 581 in das Substrat 51 ausdiffundiert. Dadurch entsteht ein dotiertes Gebiet 59, das die aktive Basis 52 mit der inaktiven Basis 53 verbindet. Auf diese Weise wird der Basisanschlußwiderstand deutlich verbessert. Die Anordnung des dotierten Gebietes erfolgt selbstjustiert über die Bildung des Spacers 58.

## Patentansprüche

1. Verfahren zur Herstellung eines dotierten Gebietes in einem Substrat mit folgenden Schritten:
a) auf der Oberfläche des Substrats (21) aus Halbleitermaterial wird eine Struktur (25) gebildet, die eine senkrechte Flanke (26) aufweist,
b) auf der mit der Struktur (25) versehenen Oberfläche des Substrats (21) wird eine Zwischenschicht (22) ganzflächig und konform erzeugt,
c) auf der Zwischenschicht (22) wird ganzflächig und konform durch CVD-Abscheidung von (B(OSi)CH₃)₃)₃) eine dotierte Glasschicht (23) erzeugt,
d) in einem anisotropen Ätzprozeß werden die dotierte Glasschicht (23) und die Zwischenschicht (22) rückgeätzt, so daß an der senkrechten Flanke (26) ein Ätzresiduum (27) entsteht,
e) in einem Temperaturschritt wird das dotierte Gebiet (24) in dem Substrat (21) durch Ausdiffusion aus dem Ätzresiduum (27) gebildet,
f) die Zwischenschicht (22), durch die der Dotierstoff bei der Bildung des dotierten Gebietes (24) diffundiert, wird aus einem Material gebildet, das als Diffusionsbarriere für den Dotierstoff wirkt, so daß sie die Dotierstoffkonzentration im dotierten Gebiet (24) begrenzt.

2. Verfahren nach Anspruch 1,
bei dem das Substrat (21) aus einkristallinem Silizium besteht.

3. Verfahren nach Anspruch 1 oder 2,
bei dem die CVD-Abscheidung bei 800 bis 850°C durchgeführt wird.

4. Verfahren nach einem der Ansprüche 1 bis 3,
bei dem die Zwischenschicht (22) durch thermische Oxidation in einer Dicke von bis zu 30 nm gebildet wird.

5. Verfahren nach einem der Ansprüche 1 bis 3,
bei dem die Zwischenschicht (22) durch CVD-Abscheidung von Si(OC₂H₅)₄ (TEOS) in einer Dicke von 10 bis 100 nm gebildet wird.

6. Verfahren nach einem der Ansprüche 1 bis 5,
bei dem der Temperaturschritt zur Ausdiffusion bei 850°C bis 1000°C während 4 bis 20 min oder bei 900°C bis 1100°C während 1 bis 120 sec. erfolgt.

7. Verfahren nach einem der Ansprüche 1 bis 6,
bei dem die dotierte Glasschicht und die Zwischenschicht nach dem Temperaturschritt zur Ausdiffusion entfernt wird.

8. Verfahren nach einem der Ansprüche 1 bis 7,
bei dem die Struktur (25) an der Oberfläche des Substrats (21) dotiertes polykristallines Silizium (251) enthält.

9. Anwendung des Verfahren nach einem der Ansprüche 1 bis 8 bei der Herstellung eines Bipolartransistors.

## Claims

1. Method for the production of a doped region in a substrate, having the following steps:
a) a structure (25) that has a vertical side edge (26) is formed on the surface of the substrate (21) of semiconductor material,
b) an intermediate layer (22) is formed surface-wide and conformally on the surface of the substrate (21) provided with the structure (25),
c) a doped glass layer (23) is produced surface-wide and conformally on the intermediate layer (22) by chemical vapour deposition of (B(OSi)CH₃)₃)₃),
d) in an anisotropic etching process, the doped glass layer (23) and the intermediate layer (22) are etched back so that an etching residue (27) is formed on the vertical side edge (26),
e) in a heat-treatment step, the doped region (24) is formed in the substrate (21) by diffusion out from the etching residue (27),
f) the intermediate layer (22), through which the dopant diffuses when the doped region (24) is formed, is formed from a material which acts as a diffusion barrier for the dopant, so that it limits the dopant concentration in the doped region (24).

2. Method according to Claim 1, in which the substrate (21) consists of monocrystalline silicon.

3. Method according to Claim 1 or 2, in which the chemical vapour deposition is carried out at 800 to 850°C.

4. Method according to one of Claims 1 to 3, in which the intermediate layer (22) is formed by thermal oxidation at a thickness of up to 30 nm.

5. Method according to one of Claims 1 to 3, in which the intermediate layer (22) is formed by chemical vapour deposition of Si(OC₂H₅)₄ (TEOS) at a thickness of 10 to 100 nm.

6. Method according to one of Claims 1 to 5, in which the heat-treatment step for diffusing out takes place at 850°C to 1000°C for 4 to 20 min or at 900°C to 1100°C for 1 to 120 sec.

7. Method according to one of Claims 1 to 6, in which the doped glass layer and the intermediate layer are removed after the heat-treatment step for diffusing out.

8. Method according to one of Claims 1 to 7, in which the structure (25) on the surface of the substrate (21) contains doped polycrystalline silicon (251).

9. Application of the method according to one of Claims 1 to 8 in the production of a bipolar transistor.

## Revendications

1. Procédé pour la formation d'une région dopée dans un substrat, comprenant les étapes ci-après:
a) sur la surface du substrat (21) constituée par une matière à semiconducteurs, on forme une structure (25) qui présente un flanc vertical (26),
b) sur la surface du substrat (21) munie de la structure (25), on génère une couche intermédiaire (22) sur toute la surface et qui épouse sa forme,
c) sur la couche intermédiaire (22), on génère, sur toute la surface et de manière à épouser sa forme, par précipitation CVD de (B(OSi(CH₃)₃)₃), une couche de verre dopé (23),
d) dans un procédé de gravure anisotrope, on soumet la couche de verre dopé (23) et la couche intermédiaire (22) à une gravure en retrait, si bien que l'on obtient un résidu de gravure (27) sur le flanc vertical (26),
e) dans une étape de traitement thermique, on forme la zone dopée (24) dans le substrat (21) par diffusion complète à partir du résidu de gravure (27),
f) on forme la couche intermédiaire (22) à travers laquelle diffuse la matière de dopage lors de la formation de la zone dopée (24), à partir d'une matière qui fait office d'arrêt de diffusion pour la matière de dopage de telle sorte qu'elle limite la concentration en substance de dopage dans la zone dopée (24).

2. Procédé selon la revendication 1, dans lequel le substrat (21) est constitué par du silicium monocristallin.

3. Procédé selon la revendication 1 ou 2, dans lequel on effectue la précipitation CVD à une température de 800 à 850°C.

4. Procédé selon l'une quelconque des revendications 1 à 3, dans lequel on forme la couche intermédiaire (22) par oxydation thermique avec une épaisseur allant jusqu'à 30 nm.

5. Procédé selon l'une quelconque des revendications 1 à 3, dans lequel on forme la couche intermédiaire (22) par précipitation CVD de Si(OC₂H₅)₄ (TEOS) en une épaisseur de 10 à 100 nm.

6. Procédé selon l'une quelconque des revendications 1 à 5, dans lequel la température de traitement thermique pour la diffusion complète a lieu à une température de 850°C à 1000°C pendant un laps de temps de 4 à 20 minutes ou bien à une température de 900°C à 1100°C pendant un laps de temps de 1 à 120 secondes.

7. Procédé selon l'une quelconque des revendications 1 à 6, dans lequel on élimine la couche de verre dopé et la couche intermédiaire après l'étape de traitement thermique pour la diffusion complète.

8. Procédé selon l'une quelconque des revendications 1 à 7, dans lequel la structure (25) à la surface du substrat (21) contient du silicium polycristallin dopé (251).

9. Utilisation du procédé selon l'une quelconque des revendications 1 à 8, dans la préparation d'un transistor bipolaire.
